# EUROPEAN PATENT APPLICATION

(11) **EP 1 152 456 A2**
(43) Date of publication of application: **07.11.2001**
(21) Application number: 01304046.4
(22) Date of filing: 03.05.2001
(51) Int. Cl.: H01L 21/00

(54) **Method and apparatus for robots having temperature sensitive applications**

(30) Priority: 04.05.2000 US 565592
(71) Applicant: Applied Materials, Inc., Santa Clara, California 95054 (US)
(72) Inventor: Sundar, Satish, Milpitas, California 95035 (US)
(74) Representative: Bayliss, Geoffrey Cyril

(57) **Abstract**

A method of operating a robot (132) having a first end effector element (174) and a second end effector element (176). The robot performs object transfers of one or more objects (128) between multiple process chambers (104, 106, 108, 110). The robot transports a plurality of objects between a first process chamber, a second process chamber, and a third process chamber. The first process chamber operates at a similar temperature as the second process chamber. The third process chamber operates at different temperature than either the first process chamber or the second process chamber. The robot performs all object transfers from the first process chamber to the second process chamber using the first end effector portion. The robot further performs all object transfers from the second process chamber to the third process chamber using a second end effector portion. In one embodiment, the first end effector portion may be able to be inserted into a process chamber separately from the second end effector portion. In another embodiment, a combined end effector may be formed with a combined first end effector portion (302) and an attached second end effector portion (306).

## Description

The invention relates to robots. More particularly, the invention relates to robot end effectors.

Semiconductor substrates or wafers are processed to produce integrated circuits using a series of sequential processes. These steps are performed using a plurality of process chambers. An assemblage of process chambers served by a wafer transport robot is known as a cluster tool. Many of the sequential processes performed in different ones of, or the same, process chambers are often performed at a different temperature.

Typical robots for objects such as semiconductor wafers are located in a transfer chamber immediately outside one or more of these process chambers. In this manner, they can transfer wafers between various process chambers to perform sequential processes occurring in different process chambers, metrology chambers, or load locks. The temperature of a wafer can be altered significantly by thermal conduction with the end effector with which the wafer is being supported, and is in physical contact.

The term "end effector" as used in this disclosure is intended to describe different embodiments of end effectors, robot blades, or any device connected to the distal end of a robot arm that is configured to support a substrate during positioning or transfer of the substrate. When the end effector transfers a wafer between a series of process chambers (at least one of the process chambers are maintained at different temperatures from the remainder of the process chambers), the temperature of the end effector may be effected by the temperature of a previous process in which the end effector was inserted, or a wafer which the end effector previously contacted. A wafer positioned inside a process chamber may be lower, higher, or approaching the local temperature inside the process chamber. When the end effector contacts a wafer, the temperature of the two elements tend to approach each other, and may eventually equalize due to a combination of thermal radiation and convection.

When the end effector contacts a wafer inside a process chamber, the temperature of the end effector often rises as a result of conduction. When the end effector is then moved to a second chamber, it may take a considerable amount of time before the temperature of the end effector equilibrates to the temperature of the second process chamber. Much of the time for temperature equalization is due to the amount of latent thermal energy stored in the end effector. Since the end effector is able to store more thermal energy due to the relative material and larger size of the end effector compared to a typical semiconductor wafer, the temperature of the end effector typically adjusts at a slower rate than the wafer when the wafer is placed in contact with the end effector. It is desired to limit contact between a wafer and the end effector that vary in temperature by too much since a temperature gradient may be established across the wafer. The temperature gradient may effect the quality of the process film and/or the ability to perform a particular process. The time for temperature equalization is increased if there is a substantial temperature difference between the two process chambers. This increased time for temperature equalization reduces the potential throughput of objects within the process chamber.

Therefore, a need exists in the art for a method that increases throughput in cluster tools having process chambers with widely varying temperature gradients.

Many disadvantages associated with the prior art are overcome with the present invention that uses a robot having a first end effector element and a second end effector element. The robot performs object transfers of one or more objects between multiple process chambers. In one embodiment, the robot performs object transfers of a plurality of objects between a first process chamber, a second process chamber, and a third process chamber. The first process chamber operates at a similar temperature as the second process chamber. The third process chamber operates at a significantly different temperature than either the first process chamber or the second process chamber. The robot performs all object transfers from the first process chamber to the second process chamber using the first end effector portion. The robot further performs all object transfers from the second process chamber to the third process chamber using a second end effector portion. In one embodiment of an end effector, the first end effector portion is positioned on a different robot arm, or a different portion of the same robot art from the second end effector portion. The first end effector thus may be able to be inserted into a process chamber separately from the second end effector portion.

In another embodiment, a combined end effector may be formed with a first end effector portion rigidly connected by an insulative member to a second end effector portion. For example, the back side of the first end effector portion is secured to the back side of the second end effector portion by an insulative material. The combined end effector is attached to a robot arm by a flipper portion such that the either the first end effector portion or the second end effector portion can be moved into a position to support an object. The combined end effector can be inserted into a single process chamber. Since only one of the first end effector portion or the second end effector portion supports (and is in contact with) the object, only that end effector portion transfers a considerable amount of heat to the object via thermal conductivity.

The teachings of the present invention can be readily understood by considering the following detailed description in conjunction with the accompanying drawings, in which:
FIG. 1 shows a top cross-sectional diagram of one embodiment of cluster tool comprising a plurality of process chambers;
FIG. 2 shows a top cross-sectional diagram of another embodiment of a cluster tool having a robot with a plurality of end effectors, each end effector is configured to carry one object;
FIG. 3 shows an expanded perspective view of the robot shown in FIG. 2;
FIG. 4 shows a flow chart of one embodiment of method performed by the controller shown in FIGs. 1 or 2 in transferring an object between multiple ones of the process chambers;
FIG. 5 shows a partial cross-sectional view of a portion of a temperature controllable end effector;
FIG. 6 shows a top perspective view of an alternate embodiment of end effector; and
FIG. 7 shows a side cross-sectional view as taken through section lines 7-7 of FIG. 6.

To facilitate understanding, identical reference numerals have been used, where possible, to designate identical elements that are common to the figures.

After considering the following description, those skilled in the art will realize that the teachings of the invention can be readily utilized in robotic systems. A single robot is configured to manipulate a plurality of end effectors. Each end effector transports objects between only certain ones of the process chambers.

### 1. Process Chamber Configuration

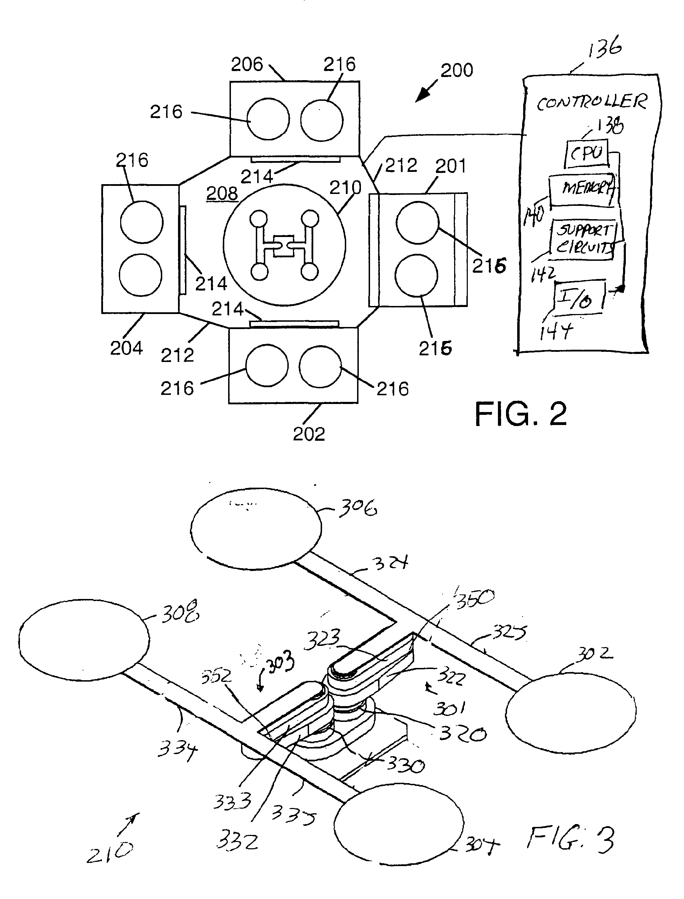

FIG. 2 shows a first embodiment of cluster tool 200 comprising three process chambers 202, 204, and 206 that are interconnected by a transport chamber 208, a twin-dual arm robot 210, and a load lock chamber 201. The twin-dual arm robot 210 is shown in greater detail in FIG. 3. Such arms for dual arm robots are made by such companies as GENMARK AUTOMATION, INC.; EQUIPE; and ADEPT TECHNOLOGY. An example of a cluster tool equipped to process two objects through a progression of process chambers simultaneously using such dual arm robots is known by the registered trademark "PRODUCER", and is manufactured by APPLIED MATERIALS, INC.

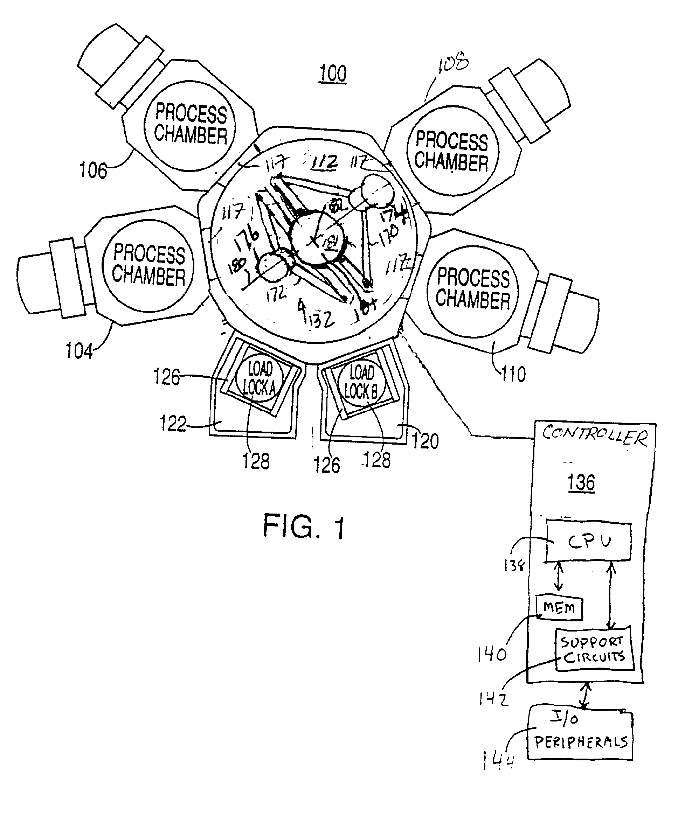

The individual process chambers 202, 204 and 206 in FIG. 2 may operate in a similar manner as, and be configured similarly to, process chambers 104, 106, 108, and 110 in FIG. 1. Examples of processes performed in such process chambers include, but are not limited to, chemical vapor deposition (CVD), physical vapor deposition (PVD), deposition, metal etching and electroplating.

Process chambers 202, 204, and 206 each have a slit valve 214 and process chambers 104, 106, 108, and 110 each have a slit value 117 configured to permit access to the interior of the process chamber by a wafer carried by an end effector. The outer periphery of the transport chamber 208 is defined by enclosure 212. Alternatively, one or more of the process chambers 202, 204, and 206 may be stand-alone units without an interconnecting transport chamber. The embodiments shown in FIGs. 1 and 2 include a controller 136 as will be described below.

The twin-dual arm robot 210 depicted in the embodiment shown in FIG. 2 will now be described, and comprises a first dual robot linkage 301 and a second dual robot linkage 303. The first dual robot linkage 301 comprises a robot hub 320, a plurality of extendable robot links 322, 323 that are hinged at 350, interconnected robot arms 324, 325, and a plurality of end effectors 302, 306. The second dual robot linkage 303 comprises a robot hub 330, a plurality of robot links 332, 333 that are hinged at 352, interconnected robot arms 334, 335, and a plurality of end effectors 304, 308.

In FIG. 2, assume pairs of objects 128 are routed by twin-dual arm robot 210 in a clockwise direction from load lock 201, to process chamber 202, to process chamber 204, to process chamber 206, and back to load lock 201. Any other type of routing that that transmits objects between the different process chambers may be used while remaining within the intended scope of the present invention.

Although two robot linkages 301 and 303 are shown in FIG. 2, it is envisioned that the operation of the cluster tool 200 could utilize only one robot linkage 301 (assume robot linkage 303 is removed). Assuming that only one robot linkage is used, only one wafer (instead of a pair of wafers) is transferred between successive process chambers.

The embodiment of cluster tool 100 shown in FIG. 1 comprises, for example, four process chambers 104, 106, 108, 110, a transfer chamber 112, and a pair of load lock chambers 120 and 122. Each process chamber 104, 106, 108, 110 is typically configured to provide a different processing stage or phase on an object (e.g. semiconductor wafer). Each process chamber 104, 106, 108 and 110 communicates with the transfer chamber 112 through a sealable slit valve 117. The slit valve 117 may be opened in a known manner to provide insertion of a wafer carried by an end effector into the respective process chamber 104, 106, 108, or 110. Though the disclosure describes objects such as semiconductor wafers being transferred within the process chamber, it is envisioned that the present invention may be applied to any type of substrate or object known in the art to be transferred by robots.

### 2. Multiple Blade Robot Embodiment

To transfer wafers between multiple ones of the process chambers 104, 106, 108, and 110, one embodiment of robot 132 is located in the transfer chamber 112 shown in FIG. 1. The robot 132 is a dual blade robot, and comprises a first robot link 170 and a second robot link 172. The first robot link 170 supports and displaces a first end effector 174 while the second robot link 172 supports and displaces a second end effector 176. End effectors 174, 176 that are located at a distal end of respective robot links 170, 172 each are configured to carry individual objects 128, such as wafers or other semiconductor substrates. The robot links 170 and 172 of the robot 132 are configured such robot links 170, 172 may extend their respective end effectors 174, 176 a desired distance from axis 182 along an extension line 180. The inclination of extension line 180 may be changed (within the horizontal plane) by rotation of robot hub 181 about a vertical axis 182. The use of a dual (or multiple) end effectors 174, 176 by the robot 132 allows the controller 136 to select one of a plurality of end effectors to transfer objects between the plurality of process chambers 104, 106, 108, and 110.

Objects 128, (such as wafers) are typically loaded in a cassette 126 that is located within one of the load lock 120 or 122. The cassettes store a plurality of objects in a vertically aligned configuration. The cassettes may be displaced vertically so a desired one of the stored objects contained in the cassette may be aligned with the desired end effector 174, 176 to permit loading of the desired object by the end effector. Robot 124 transports objects 128 (e.g. wafers) one at a time from the cassette 126 in load lock 120 or 122 to any of the process chambers 104, 106, 108, or 110. Individual wafers that are to be processed in the cluster tool are carried by end effectors 174, 176 mounted to and displaced by the robot 132. The end effectors displace the wafers between different ones of the process chambers in series, depending upon the specific desired processing to be performed upon the object. The end effectors 174, 176 are located at the distal end of the first robotic mechanism 124 in a position to provide for transfer, lifting, retraction, and or extension of the object.

The processing of objects such as semiconductor wafers often requires that one object (or a pair of objects in the embodiment shown in FIG. 2) be transferred through a succession of many process chambers. Process chambers 104, 106, 108 and 110 are configured to perform a variety of processes such as physical vapor deposition (PVD), chemical vapor deposition (CVD), electroplating, etching, or metal deposition processes, etc. The robots 124, 132 can most conveniently perform these sequential steps when the multiple process chambers are positioned physically close to each other. Process chambers 104, 106, 108, 110 typically operate at different temperatures to perform varied processes'. Typically the object is maintained at the desired temperature by conditioning the temperature of the individual process chamber.

One embodiment of the invention involves the use of dual arm robots for temperature sensitive applications such as spin-on dielectrics, this embodiment is now described. This embodiment may be applied to either the cluster tool 100 of FIG. 1, the cluster tool 200 of FIG. 2, or any known assembly of independent process chambers or cluster tools. It is important that the temperature of an object be maintained at a steady value for certain processes. Thus, the temperature of the end effector should approximate the temperature of an object (such as wafer) during processing in the process chamber 202. Achieving this temperature equality between the object and the end effector in cluster tools 100 and 200 relies upon maintaining the end effector temperature at approximately the temperature of process chamber 202.

If the end effector is moved between different process chambers 104, 106, 108, and 110 operating at different temperatures then it is difficult to maintain the end effector at the appropriate temperature of the process chambers that the end effectors are being moved into without affecting throughput. Also, if the temperature of the end effector differs from the temperature of the object it is contacting, it is difficult to maintain the temperature of the object because thermal energy in the object will transfer by conduction to the end effector. If the object is transferring heat via conduction, a thermal gradient may be established across the object. If the object temperature differs significantly from the desired temperature in a temperature-sensitive application, then the quality of the processing of the object (e.g. film deposited on the wafer) will likely be affected. If a thermal gradient is established across the object in temperature sensitive applications, then the quality of the process also may not be consistent. To limit the variation of temperature between the end effectors and the process chamber in which the end effector is being inserted, the embodiments shown in FIGs . 1 and 2 use one or more end effectors to transfer objects between a first set of chambers and another one or more end effectors to transfer objects between another set of chambers. These techniques that limit temperature variation of the end effectors are especially desirable where the temperature of an object is critical to the resulting quality of the object being processed.

The above provides a general outline of a design of two embodiments of cluster tools 100, 200. It is envisioned that the present invention may be applied to other embodiments of cluster tools, or even entirely different systems that are operated at different temperatures and/or pressures.

For an example of the use of one embodiment of the present invention shown in FIG. 2, consider the temperature of process chamber 206 to be different, and higher, than the temperature of process chambers 202 and 204. The teachings of the present invention may also apply if the process chamber 206 has a lower temperature than the process chambers 202 and 204. During processing within cluster tool 200, pairs of objects 128 are considered to be moved from load lock 201, to process chamber 202, to process chamber 204, to process chamber 206, and finally to the load lock 201 once again. This sequence is then repeated with new unprocessed objects. Different sequences between the different process chambers may be used, but the above illustrative sequence provides an illustrative embodiment that can be applied to a wide variety of cluster tools and/or stand-alone units.

If a pair of end effectors of the robot transfers objects between different process chambers that are operating at different temperatures, and the wafer is temperature sensitive, the robot has to pause inside of the process chamber before picking up an object from process chamber (to achieve the desired temperature by convection). For example, suppose the same end effector transferred a first pair of objects to process chamber 202. The pair of objects are then transferred to process chamber 204, and then to process chamber 206. The pair of objects in process chamber 206 are then transferred to load lock 201. A second pair of objects are then transferred from process chamber 202 to process chamber 204. Assume that process chamber 206 is maintained at a higher temperature than process chambers 202 or 204. During the above wafer transfer progression, the same end effector that transfers wafers to and from a warmer process chamber (206) are then used to transfer another wafer to a cooler process chamber (202). The temperature of the end effectors (that are used to transfer the object) will therefore likely have a higher temperature than the process chamber 202. A pause in process chamber 202 may thus be necessary to permit the temperature of the end effector to approach the temperature of the process chamber before the wafer can be picked up. Otherwise, the temperature of an object will be changed and a thermal gradient will establish across the object as thermal energy contained in the end effector is conducted between an object and the end effector. Pauses of this type reduce the throughput of the cluster tool considerably.

To avoid this problem, the twin-dual arm robot 210 shown in FIG. 3 can be equipped with a total of four end effectors. Two end effectors 302 and 304 handle a pair of wafers simultaneously, and two other end effectors 306 and 308 handle another pair of objects simultaneously. End effectors 302 and 304 are used only to transfer wafers from process chambers where the temperatures are close to each other. For example, the robot 210 (under the control of the controller 136) uses only one pair of end effectors 302 and 304 to transfer objects 128 between process chamber 202 and process chamber 204. By comparison, the robot 210 (under the control of the controller 136) uses another pair of end effectors 306 and 308 to transfer objects between all other chambers that are operating at a different (e.g. higher) temperature, primarily between process chamber 204 to process chamber 206. The temperatures of the end effectors 302 and 304 do not have to be lowered significantly to reach the processing temperature for process chamber 202 and 204 since the end effectors 302 and 304 are not being inserted into process chamber 206. The time in which the end effector is maintained in process chamber 202 to lower the temperature is therefore reduced. This limiting of the time that the end effector is to be held in the process chamber increases the maximum throughput of objects 128 through the cluster tool 200.

While the above describes the interaction between process chambers and robots having a twin-dual arm within cluster tools in general, it is envisioned that an embodiment of the present invention may applied to either single dual arm robot. For example, the embodiments shown in FIG. 3 may be adapted as having only one dual robot linkage 301. The operation of the dual robot linkage 301 remains as described.

A controller 136, shown in FIGs. 1 and 2, controls the operation of the cluster tools 100 and 200 respectively, and the associated operation of the robot as described. The conductor 136 contains a microprocessor 138 (CPU), a memory 140 for storing the control routines, and support circuits 142, such as power supplies, clock circuits, cache and the like. Controller 136 also contains input/output peripherals 144 such as a keyboard, mouse, and display. The controller 136 is a general-purpose computer that is programmed to perform the sequencing and scheduling operations that facilitate processing and transport of the objects. The software routines that control the cluster tool are stored in memory 140 and are executed by microprocessor 138 to facilitate control of the cluster tool 200.

It is contemplated that some of the process steps discussed herein as software processes may be implemented within hardware, e.g., as circuitry that cooperate with the microprocessor to perform various process steps. Although the controller 136 is depicted as a general purpose computer that is programmed to perform various scheduling routines, the processes that are implemented by the software can be implemented as hardware as an application specific integrated circuit (ASIC) or as discrete circuit components. As such, the process steps described herein should be broadly interpreted as being equivalently performed by software, hardware, or any combination thereof.

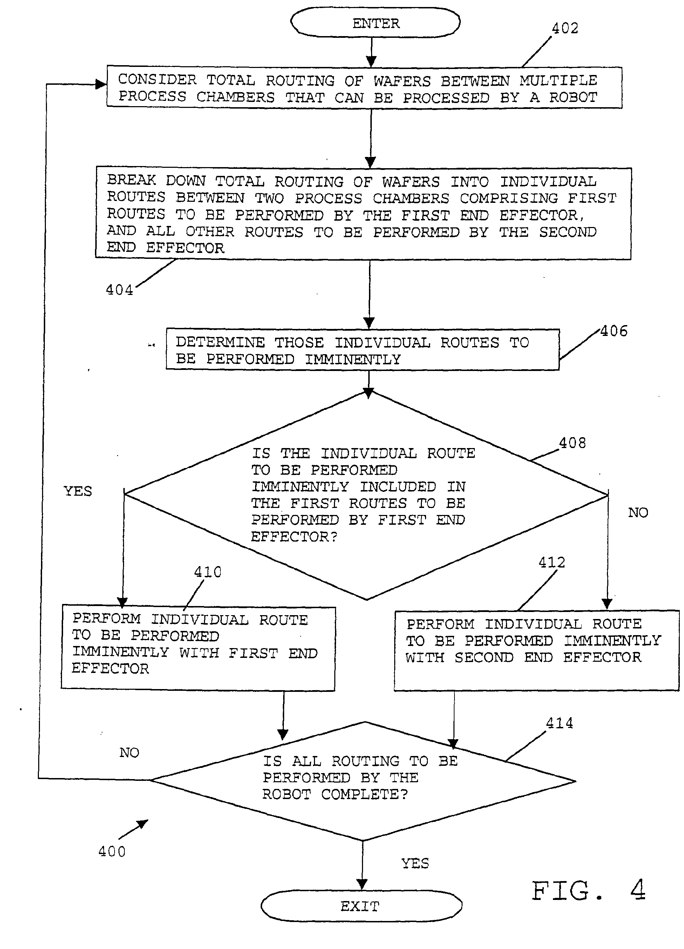

One embodiment of a method 400 performed by controller 136 that controls robot motion by determining which end effectors to be used to transfer objects between certain process chambers is depicted in FIG. 4. Controller 136 controls the processing necessary to transfer objects between multiple process chambers in the cluster tool 100 or 200, including the operation of the robots 124, 132 (shown in FIG. 1), and 210 (shown in FIG. 2). The controller 136 begins method 400 at step 402 by considering the total routing of the wafers between multiple process chambers in which either a first end effector or a second end effector can transport the different objects. In FIG. 1, for example, robot 132 having multiple end effectors 174, 176 might transfer an object between any ones of multiple process chambers 104, 106, 108, and 110. By comparison, in the FIG. 2 embodiment, the twin-dual arm robot 210 comprising end effectors 302, 304, 306, and 308, may transfer pairs of objects between the process chambers 202, 204, 206. As such, the total permutations of routing between the different process chambers 104, 106, 108, and 110 by robot 124, 133, or 210 may be considered as the "total routing" of the objects.

Method 400 continues to step 404 in which the controller 136 breaks down the total routing of objects into plurality of individual routes in which a pair of (or a single) wafer is transferred between two process chambers. The plurality of routes comprises those first routes to be performed by the first end effector, and all other "second" routes to be performed by the second end effector. The first end effector is limited to transferring an object or objects between those process chambers that are at approximately the same temperature. For example, assume in FIG. 1 that process chambers 104 and 106 operate at nearly the same process chamber 104 and process chamber 106 are at the same temperature, while process chambers 108 and 110 each operate at somewhat different temperatures then the process chambers 104 and 106.

The first end effector (which we assume to be 176), is provided to transfer all wafers between process chamber 104 to 106, but it is not inserted into process chambers 108 or 110 that are at different temperatures. Therefore, the temperature of the first end effector should be maintained at approximately the temperature of process chamber 104 and 106.

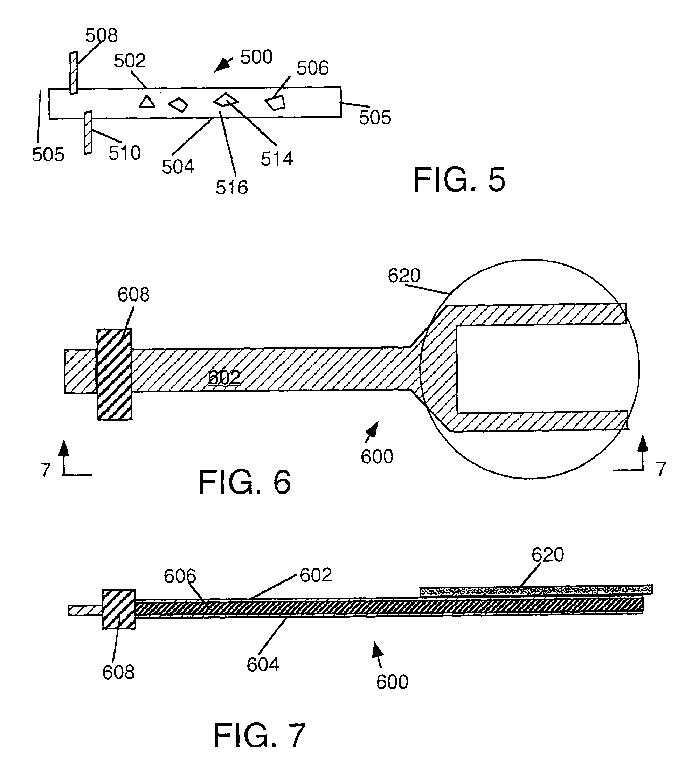

This maintaining the temperature of the end effector can be enhanced by using the embodiment of end effector 500 shown in FIG. 5. The end effector 500 includes a first plate 502, a second plate 504, end plates 505, side plates (not numbered) a honeycomb structure 506, a fluid inlet 508, and a fluid outlet 510. The honeycomb structure is formed from individual honeycombs 512 that are constructed from metal. The honeycombs are typically configured in a closed geometric shape such as triangles, rectangles, or pentagons, although any closed geometric shape may be used for honeycombs. Only a few honeycomb structures are depicted in the embodiment shown in FIG. 5, wherein many more honeycomb structures would typically be provided in such an end effector to enhance the structural strength of the end effector. The honeycomb structures are to be sufficiently spaced to enable the fluid passing into the end effector 500 from the fluid inlet 508 to pass through the interior of substantially all of the end effector 500, and then exit via the fluid outlet 510. The flow rate into the end effector 500 through fluid inlet 508 equals the fluid flow rate out of fluid outlet 510, and must be sufficient to transfer the excess heat. The closed geometric shape of each honeycomb surrounds an interior portion 514, and each honeycomb is surrounded by an exterior void 516.

During operation, a heat transfer fluid is injected into the exterior void 516 through the fluid inlet 508, and the heat transfer fluid circulates through the exterior void 516 to transfer the heat applied to the end effector 500. The heat transfer fluid present in the exterior void exits through the fluid outlet 510, and circulates to a heat transfer device (not shown). The heat transfer device is preferably a heat transfer element that maintains the temperature of the heat transfer fluid to a desired temperature (by sinking the excessive heat) before returning it into the fluid inlet 508. The fluid outlet 510, heat exchanger, fluid inlet 508, the exterior void 516 in the end effector, and the various connectors extending between these elements define a closed loop within which the temperature maintaining fluid continually circulates.

As soon as end effector 500 moves an object from process chamber 104 to process chamber 106, it can insert another object in process chamber 104 without changing the temperature of that object. As such, processing can begin within process chamber 104 soon after the robot inserts another object having a suitable temperature therein.

All transfer of objects between process chamber 106 and 108 or between process chambers 108 and 110 (that are maintained at elevated temperatures) is to be accomplished by the second and effector 174. The second end effector can quickly enter process chambers 104 or 106 (after being contained in process chambers 108 or 110) without waiting for thermal equalization since the end effector is closer to the temperature of the process chamber that the object is to be processed in, and not the temperature of the process chamber that the object is being removed from. As such, the use of first end effector 176 increases the overall throughput where compared to transferring each object through all process chambers with a single end effector. The use of the second end effector 176 may not effect the overall throughput when compared to transferring each object through all process chambers with a single end effector.

After step 404 of method 400 is completed, the controller 136 continues to step 406 in which it determines those individual routes to be performed imminently. These are those routes, comprising either first routes or second routes of step 404, that the robot is in a position to perform at the present time. The individual routes to be performed imminently, as with all other individual routes, are considered as being made up of transfer of objects between two process chambers (or alternatively) between a process chamber and a load lock.

The method 400 then continues to decision step 408 in which the controller 136 considers whether the first route to be performed by the first end effector. If the answer to decision step 408 is "YES", then the method continues to step 410 in which the controller 136 authorizes progressing using the first end effector. Controller 136 causes the robot 132 or 210 to move end effector 174, 176, or alternatively two pairs of end effectors 306, 308 or 302, 304 to perform the routes. A first pair of end effectors 302, 304 will transfer objects between chambers having approximately the same temperature.

If the answer to decision step 408 is "NO", then the controller 136 authorizes the second end effector (or second pair of end effectors 306, 308) to transfer the objects(s). Controller 136 will then cause robot 132 or 210 to move end effector 174 or 176, or alternatively a pair of end effectors 306 and 308, or 302 and 304, to perform the routes using the second end effectors and which will transfer wafers between process chambers having different temperatures. The presumption in the operation of the controller 136 is that maintaining the temperature of the second end effector is not as important for increasing the throughput of the corresponding processes as maintaining the temperature of the first end effector(s).

During typical processing, an end effector can be positioned in a heated process chamber, and the temperature of the end effector will typically be maintained at approximately the temperature that it was when it entered the process chamber since the amount of time the end effector is in the process chamber is relatively brief. For example, during typical processing, an end effector may be in a process chamber for several seconds to drop off or pick up a wafer. The amount of time that the end effector is positioned outside of any one process chamber is typically much larger compared with the amount of time that the end effector is contained within the process chamber. It is actually often repeated insertions of an end effector in one specific process chamber that can significantly affect the temperature of the end effector.

The controller 136 may base its determination of temperature of the different process chambers either upon general known operation of the cluster tool of by quantitative measurements. An example of general operation is that the controller 136 may assume that process chambers 104 and 106 generally operate at similar temperatures while process chambers 108 and 110 generally operate at higher temperatures. Certain end effectors may be used for routes between different process chambers accordingly. The specifics of the general operation of the controller are input by the user of the controller based upon knowledge of the operation of the specific cluster tool and its process chambers.

By comparison, an example of quantitative measurement as applied to the controller 136 utilized in the embodiments shown in FIGs. 1 and 2 might be actual temperature measurements within process chambers 202 and 204 as measured at a specific time during operation of the cluster tool. The quantitative measurements may be used to determine, for example, which end effectors can be used between different ones of the process chambers. The use of certain end effectors to transfer objects between certain ones of the process chambers may be applied accordingly.

After either step 410 and step 412 is performed, the process continues to decision step 414 in which the controller 136 considers whether all routing to be performed by the robot has been completed. If the answer to decision step 414 is NO, then the controller 136 returns to step 402 to loop through the method once again. During the subsequent looping through method 400, different routes will be determined to be the routes that are to be performed imminently. In this manner a continual progression of objects will be maintained through the different process chambers. If the answer to step 414 is "YES", then the controller 136 halts method 400. Method 400 is preferably performed at intervals (e.g. every 30 seconds). The controller 136 will properly handle the routing if any routes have to be performed imminently.

It is noted that while all routes in FIGs. 1 and 2, relative to FIG. 4, have been shown in the general clockwise directions, there is no reason that any combination between different process chambers, other chambers, and load locks, can be considered as routing. For example, while the first route in method 400 is described as being those routes from process chamber 104 to 106 (since process chambers 104 and 106 are at similar temperatures) the route from process chamber 106 to 104 is also to be considered a first route. Any route performed between process chambers having temperatures within the range of the temperature-sensitive application may be considered as a first route.

### 3. Single Blade Robot Embodiment

Another embodiment of end effector 600 that contains a plurality of end effector portions, each end effector portion may be used to transfer objects between different process chambers is shown in FIGs. 6 and 7. In this embodiment, a single end effector element comprises a first end effector portion 602 and a second end effector portion 604. End effector portion 602 is used to transfer objects between one set of process chambers, while the end effector 600 can be flipped about an axis to permit end effector portion 604 to be is used to transfer objects between another set of process chambers.

When considering the end effector 600, FIGs. 6 and 7 should be viewed in combination. The end effector comprises a first end effector portion formed as outer layer 602, a second end effector portion formed as outer layer 604, an insulative layer 606, and a flipper element 608. The first end effector portion 602 and the second end effector portion 604 is preferably formed from an aluminum, a stainless steel, a composite, or some other material depending largely upon the chemicals that are applied to the process chamber in which the end effector 600 will be inserted. The end effector portions 602, 604 are each configured, and have the general shape, as a single end effector described above. The end effector portions 602 and 604 are positioned in a back-to-back orientation such that the sides of the end effector portions 602, 604 that are configured to support an object (such as a wafer 620) face opposite directions. In this orientation, when the first end effector portion 602 is facing upwardly the second end effector portion 604 is facing downward, and vice versa. The flipper element 608 acts to flip the end effector 600 between the end effector portion 602 or 604 that is in a position to support the object 620 (for example the other end effector portion may be inverted and incapable of supporting the object). While it is most common in semiconductor processing that the robot supports an object from below, it is to be understood that there are those applications that the end effector supports the top of the object 620 by vacuum chucking (for example in electroplating, not shown), or even that the object 620 may be supported by the end effector in a sideways position.

The end effector 600 positions only one object at a time in a process chamber. Assume that the first end effector portion 602 that is facing up is the one that is in contact with, and supporting, the wafer. The assignment of the first end effector portion 602 and the second end effector portion 604 is arbitrary since both end effector portions are configured similarly and perform similar operations. The end effector portion 602 or 604 that is oriented in a particular direction may also be switched by actuating the flipper element 608.

The object will not be contacting the second end effector portion 604 that is directed downwardly in the embodiment shown in FIG. 6 when being supported by the end effector in the orientation shown in FIGs. 6 and 7. Heat is therefore not being transmitted between the second end effector portion 604 and the wafer 620 by thermal conduction. Any heat loss of the end effector portion that is not contacting the wafer is though thermal convection. It typically requires a considerably longer time to transfer thermal energy contained in an end effector 602 or 604 through thermal convection than thermal conduction, so the temperature variation to the second end effector portion 604 when inserted into a process chamber for several seconds before removal therefrom, is not significant.

Although various embodiments that incorporate the teachings of the present invention have been shown and described in detail herein, those skilled in the art can readily devise many other varied embodiments that still incorporate these teachings.

## Claims

1. A method of performing object transfers between a first process chamber, a second process chamber, and a third process chamber using a robot having a first end effector portion and a second end effector portion, the first process chamber operating at a similar temperature to that of the second process chamber, and the third process chamber operating at different temperatures from the first process chamber or the second process chamber, the method comprising:
performing all object transfers from the first process chamber to the second process chamber using the first end effector portion; and
performing all object transfers from the second process chamber to the third process chamber using the second end effector portion.

2. A method as claimed in claim 1, wherein the first end effector portion and/or the second end effector portion is/are capable of carrying a single object.

3. A method as claimed in claim 1, wherein the first end effector portion and the second end effector portion are both capable of carrying a plurality of objects.

4. A method as claimed in any of claims 1 to 3, wherein processing of the objects is temperature dependent.

5. A method as claimed in any of claims 1 to 4, wherein the second end effector portion is not used to transfer objects to or from the first process chamber.

6. A method as claimed in any of claims 1 to 5, wherein the first end effector portion is not used to transfer objects to or from the third process chamber.

7. A method as claimed in any of claims 1 to 6, wherein the object is a substrate formed primarily from a semiconductor.

8. A method as claimed in any of claims 1 to 7, wherein the object is a wafer.

9. A method as claimed in any of claims 1 to 8, wherein the first end effector portion can be positioned in a process chamber separate from the second end effector portion.

10. A method as claimed in claim 9, wherein the first end effector portion and the second end effector portion are both capable of supporting a distinct one of a plurality of said objects simultaneously.

11. A method as claimed in any of claims 1 to 10, wherein the first end effector portion and the second end effector portion can be inserted into a single process chamber simultaneously.

12. A method as claimed in claim 11, wherein only either the first end effector portion or the second end effector portion is positioned to support a wafer when the first end effector portion and the second end effector portion are inserted simultaneously into a single process chamber.

13. A computer readable medium that stores software that, when executed by a processor, causes a system to perform a method of performing object transfers between a first process chamber, a second process chamber, and a third process chamber, the first process chamber operating at a similar temperature to that of the second process chamber, and the third process chamber operating at different temperatures from the first process chamber or the second process chamber, the method comprising:
performing all object transfers from the first process chamber to the second process chamber using a first end effector portion of a robot; and
performing all object transfers from the second process chamber to the third process chamber using a second end effector portion of a robot.

14. A computer readable medium as claimed in claim 13, wherein the temperatures of the process chambers are based upon the general operating temperatures of each ones of the processing chambers.

15. A computer readable medium as claimed in claim 13 or claim 14, wherein the temperatures are based upon quantitatively measurements.

16. A method as claimed in any of claims 13 to 15, wherein the first end effector portion can be positioned in a process chamber separate from the second end effector portion.

17. A method as claimed in claim 16, wherein the first end effector portion and the second end effector portion are both capable of supporting a distinct one of a plurality of said objects simultaneously.

18. A method as claimed in any of claims 13 to 17, wherein the first end effector portion and the second end effector portion can be inserted into a single process chamber simultaneously.

19. A method as claimed in claim 18, wherein only either the first end effector portion or the second end effector portion is positioned to support a wafer when the first end effector portion and the second end effector portion are inserted simultaneously into a single process chamber.
